(19) Europäisches Patentamt
European Patent Office
Office européen des brevets

(11) **EP 4 207 964 B1**

(12) **EUROPEAN PATENT SPECIFICATION**

(45) Date of publication and mention
of the grant of the patent:
**11.03.2026   Bulletin 2026/11**

(21) Application number: **21888617.4**

(22) Date of filing: **04.11.2021**

(51) International Patent Classification (IPC):
*G06F 1/20* *(2006.01)*

(52) Cooperative Patent Classification (CPC):
**G06F 1/206**

(86) International application number:
**PCT/CN2021/128702**

(87) International publication number:
**WO 2022/095925 (12.05.2022 Gazette 2022/19)**

(54) **HEAT DISSIPATION CONTROL METHOD AND APPARATUS, HEAT DISSIPATION SYSTEM, COMPUTER DEVICE AND READABLE MEDIUM**

VERFAHREN UND VORRICHTUNG ZUR STEUERUNG DER WÄRMEABLEITUNG, WÄRMEABLEITUNGSSYSTEM, COMPUTERVORRICHTUNG UND LESBARES MEDIUM

PROCÉDÉ ET APPAREIL DE COMMANDE DE DISSIPATION DE CHALEUR, SYSTÈME DE DISSIPATION DE CHALEUR, DISPOSITIF INFORMATIQUE ET SUPPORT LISIBLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.11.2020   CN 202011230195**

(43) Date of publication of application:
**05.07.2023   Bulletin 2023/27**

(73) Proprietor: ZTE Corporation
**Shenzhen, Guangdong 518057 (CN)**

(72) Inventors:
• **LIAO, Liang**
  **Shenzhen, Guangdong 518057 (CN)**
• **SUN, Quan**
  **Shenzhen, Guangdong 518057 (CN)**
• **YU, Hongquan**
  **Shenzhen, Guangdong 518057 (CN)**

(74) Representative: **Canzler & Bergmeier Patentanwälte Partnerschaft mbB Despag-Straße 6 85055 Ingolstadt (DE)**

(56) References cited:
CN-A- 102 595 857     CN-A- 105 977 574
CN-A- 106 095 022     CN-A- 110 868 967
CN-A- 111 459 252     US-A1- 2007 103 321
US-A1- 2014 262 128   US-A1- 2015 006 937
US-A1- 2018 150 116

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### TECHNICAL FIELD

The present disclosure relates to the technical field of automatic control, and specifically relates to a heat dissipation control method and apparatus, a heat dissipation system, a computer device and a readable medium.

### BACKGROUND

Inside an electronic device, a large amount of electronic components generate heat in operation, causing a too high temperature inside the electronic device. For the electronic device with a relatively confined structure, the most direct heat dissipation mode is rapidly transferring the heat inside the electronic device to the device surface (the shell), and implementing rapid heat dissipation through the device surface. This mode has a good heat dissipation effect, can ensure that the internal temperature of the electronic device will not rise quickly, but may cause an overhigh temperature on the device surface. If a user directly contacts the device surface at this time, the user is likely to be scalded, leading to potential safety hazards.

Document US 2014/262128 A1 discloses a heat dissipation control method and apparatus where according to which surface a user is touching or close to, heat may be dissipated via one surface or another.

### SUMMARY

The present disclosure provides a heat dissipation control method according to claim 1, a heat dissipation control apparatus according to claim 5, and a computer readable medium according to claim 9.

### BRIEF DESCRIPTION OF DRAWINGS

FIG. 1 is a schematic structural diagram of a device according to an embodiment of the present disclosure;
FIG. 2 is a first schematic flowchart of a heat dissipation control method according to an embodiment of the present disclosure;
FIG. 3 is a second schematic flowchart of a heat dissipation control method according to an embodiment of the present disclosure;
FIG. 4 is a schematic structural diagram of a heat dissipation control apparatus according to an embodiment of the present disclosure; and
FIG. 5 is a schematic structural diagram of a heat dissipation system according to an embodiment of the present disclosure.

### DETAIL DESCRIPTION OF EMBODIMENTS

Example embodiments will be described more sufficiently below with reference to the accompanying drawings, but which may be embodied in different forms and should not be construed as limited to the embodiments set forth herein. Rather, these embodiments are provided so that the present disclosure will be thorough and complete, and will fully convey the scope of the present disclosure to those skilled in the art.

As used herein, the term "and/or" includes any and all combinations of one or more of the associated listed items.

The terminology used herein is for the purpose of describing specific embodiments only and is not intended to limit the present disclosure. As used herein, the singular forms "a", "an" and "the" are intended to include the plural forms as well, unless the context clearly indicates otherwise. It will be further understood that as used herein, the terms "comprise" and/or "consist of ..." specify the presence of stated features, integers, steps, operations, elements, and/or components, but do not preclude the presence or addition of one or more other features, integers, steps, operations, elements, components, and/or groups thereof.

Embodiments described herein may be described with reference to plan and/or sectional views in idealized representations of the present disclosure. Accordingly, the example illustrations may be modified in accordance with manufacturing techniques and/or tolerances. Accordingly, the embodiments are not limited to the embodiments shown in the drawings, but include modifications of configurations formed based on a manufacturing process. Thus, the regions illustrated in the figures have schematic properties, and the shapes of the regions shown in the figures illustrate specific shapes of regions of elements, but are not intended to be limiting.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the existing art and the present disclosure, and will not be interpreted in an idealized or overly formal sense unless expressly so defined herein.

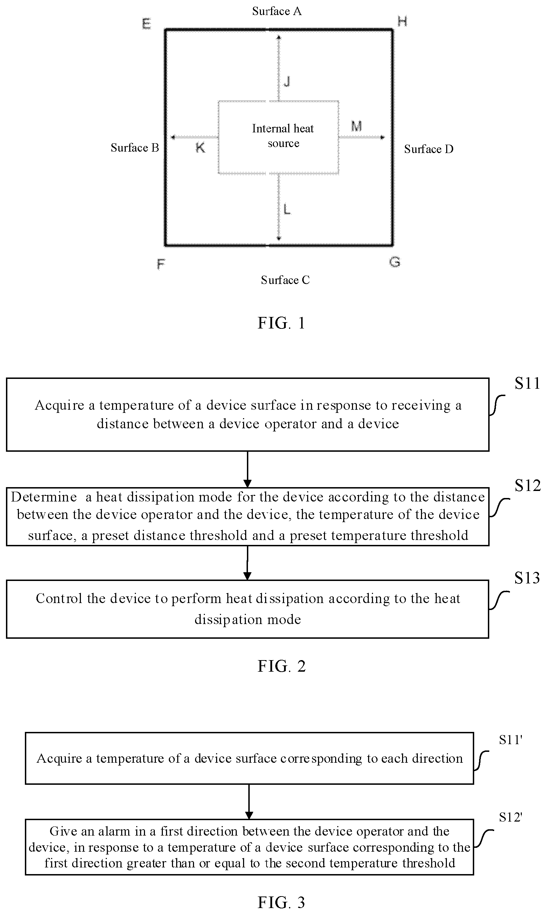

An embodiment of the present disclosure provides a heat dissipation control method for control heat dissipation of a device. The device may be a router, a customer premise equipment, a mobile phone, a television, or other electronic devices which can be directly contacted by a human body, or a device, such as a base station device, which is rarely contacted by a human body but can transfer the internal temperature to a surface of the device to cause an overhigh surface temperature. The device has a cross section as shown in FIG. 1. The device is provided with an electronic component inside as an internal heat source in operation, and the device includes four surfaces, A, B, C and D, each of which is made of a good conductor of heat. E, F, G and H are four contact locations or portions of adjacent surfaces of the device, each of which is made of a poor conductor of heat. J, K, L and M respectively indicate heat dissipation channels of the device in four directions, and the heat dissipation channels are configured to transfer heat from the internal heat source (in first to fourth directions) to the surfaces of the device. It should be noted that, in the embodiment of the present disclosure, a four-surface device is taken as an example for illustration, but those skilled in the art will understand that the device may not be limited to four surfaces, such as a device with a sphere shape, an ellipsoid shape, a cube shape, or any other irregular shape, and any type and shape of electronic device capable of dissipating heat falls within the scope of the embodiments of the present disclosure.

As shown in FIG. 2, the heat dissipation control method includes the following steps 11 to 12.

At step 11, acquiring, in response to receiving a distance between a device operator and a device, a temperature of a device surface (a surface of the device).

A distance sensor (i.e., a distance detection apparatus) having a detection range is provided on the device surface. Once a device operator approaches the device and comes within the detection range of the distance sensor, the distance sensor can detect the distance between the device operator and the device, and transmit the distance between the device operator and the device to the heat dissipation control apparatus. A temperature sensor (i.e., a temperature detection apparatus) is provided on the device surface to detect a temperature of each device surface according to a detection period, and report the detected temperature to the heat dissipation control apparatus. When the heat dissipation control apparatus receives the distance between the device operator and the device sent from the distance sensor, the temperature of the device surface corresponding to that moment is acquired.

At step 12, determining a heat dissipation mode for the device according to the distance between the device operator and the device, the temperature of the device surface, a preset distance threshold and a preset temperature threshold.

In an embodiment of the present disclosure, the device may have four heat dissipation modes, including: (1) a normal heat dissipation mode, that is, transferring heat from an internal heat source to a device surface through a heat dissipation channel; (2) a first rapid heat dissipation mode, that is, closing the heat dissipation channel, and stopping transferring heat from the internal heat source to the device surface through the heat dissipation channel, which can rapidly reduce the temperature of the device surface since the heat transfer path from the internal heat source to the device surface is cut off; (3) a second rapid heat dissipation mode, that is, closing the heat dissipation channel and starting heat dissipation on the device surface, including performing heat dissipation through a heat dissipation apparatus for the device surface while closing the heat dissipation channel, which can further reduce the temperature of the device surface rapidly; (4) a slow heat dissipation mode, that is, reducing heat transferred through the heat dissipation channel.

In this step, the heat dissipation control apparatus judges whether the distance between the device operator and the device satisfies a preset distance threshold condition, and whether the temperature of the device surface satisfies a preset temperature threshold condition, and selects an appropriate heat dissipation mode for the device according to the judgment result.

At step 13, controlling the device to perform heat dissipation according to the heat dissipation mode.

In this step, the heat dissipation control apparatus may control opening/closing of the heat dissipation channel, an amount of heat transferred through the heat dissipation channel, and opening/closing of the heat dissipation apparatus for the device surface, to ensure heat dissipation of the device in a corresponding heat dissipation mode.

In some implementations, the heat dissipation channel may be a coolant flow channel, an air flow channel, a heat transfer path, or the like between the internal heat source and the device surface. Accordingly, closing the heat dissipation channel and reducing heat transferred through the heat dissipation channel may refer to partially or completely closing the coolant or air flow channel, moving an insulation material into the heat transfer path or moving a heat transfer material away from the heat transfer path, adjusting positions of fins, and the like. The heat dissipation apparatus for' the device surface may be a Peltier element, a fan, or the like.

The heat dissipation control method according to the embodiment of the present disclosure includes: acquiring, in response to receiving a distance between a device operator and a device, a temperature of a device surface; and determining a heat dissipation mode for the device according to the distance between the device operator and the device, the temperature of the device surface, a preset distance threshold and a preset temperature threshold; and controlling the device to perform heat dissipation according to the heat dissipation mode. In this embodiment of the present disclosure, by monitoring the distance between the device operator and the device and the temperature of the device surface, heat exchange between the interior of the device and the device surface is automatically adjusted, it is ensured that the temperature of the device surface is within a human acceptable range when the device operator contacts the device surface, thus the device operator is protected from being scalded and potential safety hazards are eliminated, while normal operation of the device is ensured.

In some embodiments, the distance between the device operator and the device is a distance between the device as a whole and the device operator (different surfaces of the device are not distinguished), and the temperature of the device is a temperature of the device as a whole (different surfaces of the device are not distinguished). Therefore, the temperature sensor and the distance sensor may be arranged at any position of the device as long as the temperature detection and the distance detection can be realized. Correspondingly, in this solution, the control of heat dissipation is also for the device as a whole, and different surfaces of the device are not distinguished. For example, if it is determined that the normal heat dissipation mode is adopted, the device is controlled to transfer heat from the internal heat source to the device surfaces through four heat dissipation channels, respectively. This solution uses relatively fewer sensors and is relatively simple, but has a poor temperature control effect on the device surfaces.

In order to solve the problem of poor temperature control effect on the device surfaces, in some embodiments, temperature sensors may be provided on the respective device surfaces to detect temperatures of the respective device surfaces, and distance sensors may be provided on the respective device surfaces to detect distances between different parts of the device operator and different surfaces of the device, respectively, such as a distance between the left hand of the device operator and the first surface of the device, and a distance between the right hand of the device operator and the second surface of the device. In an embodiment of the present disclosure, in addition to the distance sensor, a sensor for recognizing a person or an object, such as an SAR (Specific Absorption Rate) sensor, may be further provided, which has a low detection accuracy, while the distance sensor, which has a relatively high detection accuracy, is configured to detect the distance. When recognizing a person approaching the device, the SAR sensor notifies the heat dissipation control apparatus to turn on the distance sensor.

Accordingly, in this embodiment, the distance between the device operator and the device is the distance between the device operator and the device in each direction (i.e., each device surface). As shown in FIG. 3, acquiring the temperature of the device surface (i.e., step 11) includes: the following step 11'.

At step 11', acquiring a temperature of a device surface corresponding to each direction. In other words, the acquired temperature(s) of the device surface(s) is/are the temperature(s) of device surface(s) against which the device operator and a body part thereof face.

Determining the heat dissipation mode for the device according to the distance between the device operator and the device, the temperature of the device surface, the preset distance threshold and the preset temperature threshold (i.e., step 12) includes: determining a heat dissipation mode for the device in each direction according to the distance between the device operator and the device in each direction, the temperature of the device surface corresponding to each direction, the preset distance threshold and the preset temperature threshold. In other words, in this step, the heat dissipation mode is determined and adjusted for each direction in which approach of a device operator to the device is detected. This solution can control the temperature of the device surface more accurately, and can have a better temperature control effect.

In some embodiments, the distance threshold may include a first distance threshold D1 and a second distance threshold D2. The second distance threshold D2 is less than the first distance threshold D1. The temperature threshold may include a first temperature threshold T1 and a second temperature threshold T2. The second temperature threshold T2 is less than the first temperature threshold T1. The first temperature threshold T1 is a safe temperature for human touch up to which there is a risk of being scalded, and T1 may be 50 °C. The second temperature threshold T2 is an alert temperature. When T2 is reached, it indicates that the safe temperature for human touch is nearly reached, and T2 may be 40 °C to 45 °C.

Determining the heat dissipation mode for the device in each direction according to the distance between the device operator and the device in each direction, the temperature of the device surface corresponding to each direction, the preset distance threshold and the preset temperature threshold includes: in a first direction between the device operator and the device, in response to the distance d between the device operator and the device in the first direction greater than the second distance threshold D2 and less than or equal to the first distance threshold D1, and the temperature t of the device surface corresponding to the first direction greater than or equal to the first temperature threshold T1, or in response to the distance d between the device operator and the device in the first direction greater than or equal to zero and less than or equal to the second distance threshold D2, and the temperature t of the device surface corresponding to the first direction less than the first temperature threshold T1 and greater than or equal to the second temperature threshold T2, determining that the heat dissipation mode of the device in the first direction is: reducing an amount of heat delivered by a heat dissipation channel of the device in the first direction.

In other words, the slow heat dissipation mode is adopted in a direction if one of the following condition is satisfied in that direction:

(1)

$$D2 < d \leq D1, \text{ and } t \geq T1;$$

and
(2)

$$0 \leq d \leq D2, \text{ and } T2 \leq t < T1.$$

When D2<d≤D1, and t≥T1, it indicates that the temperature of the current device surface (i.e., the surface facing the device operator) is relatively high, but the device operator is far away from the device, so slow heat dissipation can be performed by reducing heat delivered by the corresponding heat dissipation channel. When 0<d≤D2, and T2≤t<T1, it indicates that the device operator is close to the device, but the temperature of the current device surface (i.e., the surface facing the device operator) is not too high or too low, so slow heat dissipation can also be performed by reducing heat delivered by the corresponding heat dissipation channel. When d=0 and T2≤t<T1, it indicates that the device operator has come into contact with the device surface, but the temperature of the current device surface (i.e., the surface facing the device operator) is not too high or too low, so slow heat dissipation can also be performed by reducing heat delivered by the corresponding heat dissipation channel.

In some embodiments, determining the heat dissipation mode for the device in each direction according to the distance between the device operator and the device in each direction, the temperature of the device surface corresponding to each direction, the preset distance threshold and the preset temperature threshold includes: in a first direction between the device operator and the device, in response to the distance d between the device operator and the device in the first direction greater than the second distance threshold D2 and less than or equal to the first distance threshold D1, and the temperature t of the device surface corresponding to the first direction less than the first temperature threshold T1, or in response to the distance d between the device operator and the device in the first direction greater than or equal to zero and less than or equal to the second distance threshold D2, and the temperature t of the device surface corresponding to the first direction less than the second temperature threshold T2, determining that the heat dissipation mode of the device in the first direction is: maintaining an amount of heat delivered by a heat dissipation channel of the device in the first direction.

In other words, the normal heat dissipation mode is adopted in a direction if one of the following condition is satisfied in that direction:

(1)

$$D2 < d \leq D1, \text{ and } t < T1;$$

and
(2)

$$0 \leq d \leq D2, \text{ and } t < T2.$$

When D2<d≤D1, and t<T1, it indicates that the temperature of the current device surface (i.e., the surface facing the device operator) is not too high, and the device operator is far away from the device, so normal heat dissipation can be performed by maintaining heat delivered by the corresponding heat dissipation channel. When 0<d≤D2, and t<T2, it indicates that the device operator is close to the device, but the temperature of the current device surface (i.e., the surface facing the device operator) is relatively low, so normal heat dissipation can also be performed by maintaining heat delivered by the corresponding heat dissipation channel. When d=0 and t< T2, it indicates that the device operator has come into contact with the device surface, but the temperature of the current device surface (i.e., the surface facing the device operator) is relatively low, so normal heat dissipation can also be performed by maintaining heat delivered by the corresponding heat dissipation channel.

Further, in the case where the device operator is not detected, since there is no fear that the device operator comes into contact with the device surface, it is also possible to perform normal heat dissipation by maintaining heat delivered by the corresponding heat dissipation channel.

In some embodiments, determining the heat dissipation mode for the device in each direction according to the distance between the device operator and the device in each direction, the temperature of the device surface corresponding to each direction, the preset distance threshold and the preset temperature threshold includes: in a first direction between the device operator and the device, in response to the distance d between the device operator and the device in the first direction greater than zero and less than or equal to the second distance threshold D2, and the temperature t of the device surface corresponding to the first direction greater than or equal to the first temperature threshold T1, determining that the heat dissipation mode of the device in the first direction is: closing a heat dissipation channel of the device in the first direction, or determining that the heat dissipation mode of the device in the first direction is: closing the heat dissipation channel of the device in the first direction and turning on a heat dissipation apparatus for a device surface corresponding to the first direction.

In other words, the first or second rapid heat dissipation mode is adopted in a direction if 0<d≤D2 and t≥T1 in that direction. When 0<d≤D2 and t≥T1, the device operator is close to the device, and the temperature of the current device surface (i.e., the surface facing the device operator) is relatively high, so rapid heat dissipation is performed by closing a heat dissipation channel of the device in the first direction, or by closing the heat dissipation channel of the device in the first direction and turning on a heat dissipation apparatus for a device surface in the first direction.

In some embodiments, as shown in FIG. 3, after acquiring the temperature of the device surface corresponding to each direction (i.e., step 11'), the method may further include the following step 12'.

At step 12', giving an alarm in a first direction between the device operator and the device, in response to a temperature of a device surface corresponding to the first direction greater than or equal to the second temperature threshold.

In this step, in the process of adjusting the heat dissipation mode of the device, if the heat dissipation control apparatus determines that the temperature t of the device surface in a certain direction satisfies t≥T2, which indicates that the temperature of the device surface in that direction is very close to the safe temperature for human touch, an alarm is given to remind to pay attention to operation of the device and avoid scalding.

It should be noted that the alarm may be continued until the temperature t of the device surface is less than the second temperature threshold T2.

An embodiment of the present disclosure provides a heat dissipation control method for adjusting internal-external heat dissipation mechanisms of a device according to a distance between a human body and the device and a temperature of a device surface. The method includes: monitoring the distance between the device and the human body (i.e., a device operator) and the temperature of the device surface, and switching, when the distance between the human body and the device is smaller than or equal to a distance safety value (i.e., a second distance threshold value D2) and the temperature of the device surface is greater than or equal to a first temperature threshold value (T1), a heat dissipation mode into a rapid heat dissipation mode which takes internal heat circulation as a main mode and external heat dissipation as an auxiliary mode within a safe service temperature range of the device, that is, adjusting a position of the external heat dissipation so that internal heat is rapidly and intensively transferred to a position beyond reach of the human body; adopting, when the distance between the human body and the device is relatively long (D2<d), or the distance between the human body and the device is relatively short or even the human body has contacted the device (0≤d≤D2) and the temperature of the device surface is relatively low, a normal heat dissipation mode of a heat dissipation channel; and adopting, when the distance between the human body and the device is relatively long (D2<d) and the temperature of the device surface is relatively high (t≥T1), or when the distance between the human body and the device is relatively short or even the human body has contacted the device (0≤d≤D2) and the temperature of the device surface is not too high or too low (T2≤t<T1), a slow heat dissipation mode of reducing heat delivered by the heat dissipation channel.

In an embodiment of the present disclosure, when d=D1, the distance sensor starts monitoring the distance between the human body and the device in real time. When D2<d≤D1 and t≥T1, and when 0≤d≤D2 and T2≤t<T1, the device starts reducing the heat transferred from the inside to the outside, thereby effectively reducing the temperature of the device surface. When D2<d≤D1 and t<T1, and when 0≤d≤D2 and t<T2, the device performs normal heat dissipation by maintaining the heat delivered by the heat dissipation channel. When 0<d≤D2 and t≥T1, the device completely cuts off the heat conduction path from the internal heat source to the device surface, thereby rapidly reducing the temperature of the device surface to a safe range acceptable to human body. The embodiment of the present disclosure can, on one hand, ensure that the device will not work abnormally due to an overhigh temperature, and on the other hand, improve the comfort level of the human body when contacting the device surface, and ensure that the temperature can be reduced to a comfortable temperature range acceptable by the human body when the human body contacts the device surface. The embodiment of the present disclosure can adjust the temperature of the device surface automatically and effectively, and ensure that while normal heat dissipation is performed on internal electronic components of device, the temperature of the corresponding device surface is effectively reduced before a person approaches and touches the device surface, thereby protecting the person from being scalded.

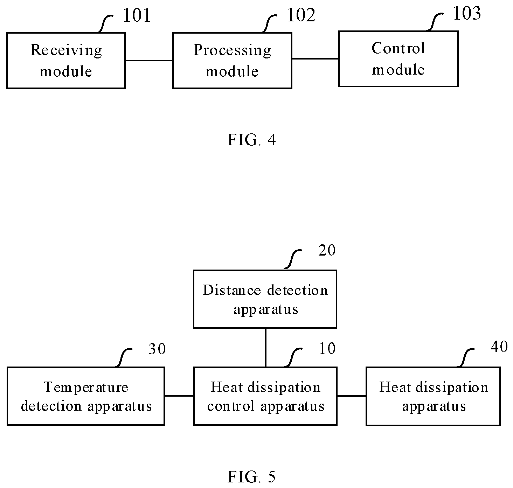

Based on the same technical concept, an embodiment of the present disclosure further provides a heat dissipation control apparatus which, as shown in FIG. 4, includes: a receiving module 101, a processing module 102 and a control module 103. The receiving module 101 is configured to receive a distance between a device operator and a device.

The processing module 102 is configured to acquire, in response to that the receiving module 101 receives the distance between the device operator and the device, a temperature of a device surface; and determine a heat dissipation mode for the device according to the distance between the device operator and the device, the temperature of the device surface, a preset distance threshold and a preset temperature threshold.

The control module 103 is configured to control the device to perform heat dissipation according to the heat dissipation mode.

In some embodiments, the distance between the device operator and the device is a distance between the device operator and the device in each direction, and the processing module 102 is configured to acquire a temperature of a device surface corresponding to each direction; and determine a heat dissipation mode for the device in each direction according to the distance between the device operator and the device in each direction, the temperature of the device surface corresponding to each direction, the preset distance threshold and the preset temperature threshold.

In some embodiments, the distance threshold includes a first distance threshold and a second distance threshold, and the temperature threshold includes a first temperature threshold and a second temperature threshold, and the processing module 102 is configured to, in a first direction between the device operator and the device, in response to the distance between the device operator and the device in the first direction greater than the second distance threshold and less than or equal to the first distance threshold, and the temperature of the device surface corresponding to the first direction greater than or equal to the first temperature threshold, or in response to the distance between the device operator and the device in the first direction greater than or equal to zero and less than or equal to the second distance threshold, and the temperature of the device surface corresponding to the first direction less than the first temperature threshold and greater than or equal to the second temperature threshold, determine that the heat dissipation mode of the device in the first direction is reducing an amount of heat delivered by a heat dissipation channel of the device in the first direction.

In some embodiments, the distance threshold includes a first distance threshold and a second distance threshold, and the temperature threshold includes a first temperature threshold and a second temperature threshold, and the processing module 102 is configured to, in a first direction between the device operator and the device, in response to the distance between the device operator and the device in the first direction greater than the second distance threshold and less than or equal to the first distance threshold, and the temperature of the device surface corresponding to the first direction less than the first temperature threshold, or in response to the distance between the device operator and the device in the first direction greater than or equal to zero and less than or equal to the second distance threshold, and the temperature of the device surface corresponding to the first direction less than the second temperature threshold, determine that the heat dissipation mode of the device in the first direction is maintaining an amount of heat delivered by a heat dissipation channel of the device in the first direction.

In some embodiments, the distance threshold includes a first distance threshold and a second distance threshold, and the temperature threshold includes a first temperature threshold and a second temperature threshold, and the processing module 102 is configured to, in a first direction between the device operator and the device, in response to the distance between the device operator and the device in the first direction greater than zero and less than or equal to the second distance threshold, and the temperature of the device surface corresponding to the first direction greater than or equal to the first temperature threshold, determine that the heat dissipation mode of the device in the first direction is closing a heat dissipation channel of the device in the first direction, or determine that the heat dissipation mode of the device in the first direction is closing the heat dissipation channel of the device in the first direction and turning on a heat dissipation apparatus on a device surface corresponding to the first direction.

In some embodiments, the temperature threshold includes a first temperature threshold and a second temperature threshold greater than the first temperature threshold, and the processing module 102 is further configured to give an alarm in a first direction between the device operator and the device, in response to a temperature of a device surface corresponding to the first direction greater than or equal to the second temperature threshold.

Based on the same technical concept, an embodiment of the present disclosure further provides a heat dissipation system which, as shown in FIG. 5, includes: a distance detection apparatus 20, a temperature detection apparatus 30, a heat dissipation apparatus 40, and the heat dissipation control apparatus 10 as described above.

An embodiment of the present disclosure further provides a computer device, including: one or more processors and a storage medium. The storage medium stores one or more programs thereon which, when executed by the one or more processors, cause the one or more processors to implement the heat dissipation control method as described in any of the above embodiments.

An embodiment of the present disclosure further provides a computer-readable medium storing a computer program thereon, where the computer program, when executed, causes the heat dissipation control method as described in any of the above embodiments to be implemented.

Those of ordinary skill in the art will appreciate that all or some operations of the above described method, functional modules/units in the apparatus may be implemented as software, firmware, hardware, and suitable combinations thereof. In a hardware implementation, the division between the functional modules/units mentioned in the above description does not necessarily correspond to the division of physical components; for example, one physical component may have multiple functions, or one function or operation may be performed cooperatively by several physical components. Some or all physical components may be implemented as software executed by a processor, such as a CPU, a digital signal processor or microprocessor, or implemented as hardware, or implemented as an integrated circuit, such as an application specific integrated circuit. Such software may be distributed on a computer-readable medium which may include a computer storage medium (or non-transitory medium) and communication medium (or transitory medium). The term computer storage medium includes volatile and nonvolatile, removable and non-removable media implemented in any method or technology for storage of information such as computer-readable instructions, data structures, program modules or other data, as is well known to those of ordinary skill in the art. The computer storage medium includes, but is not limited to, an RAM, an ROM, an EEPROM, a flash or any other memory technology, a CD-ROM, a digital versatile disc (DVD) or any other optical disc storage, a magnetic cartridge, a magnetic tape, a magnetic disk storage or any other magnetic storage medium, or may be any other medium used for storing the desired information and accessible by a computer. Moreover, it is well known to those ordinary skilled in the art that a communication medium typically includes a computer-readable instruction, a data structure, a program module, or other data in a modulated data signal, such as a carrier wave or other transport mechanism, and may include any information delivery medium.

The present disclosure has disclosed exemplary embodiments, and although specific terms are employed, they are used and should be interpreted merely in a generic and descriptive sense, not for purposes of limitation. In some instances, as would be apparent to one skilled in the art, features, characteristics and/or elements described in connection with a particular embodiment may be used alone or in combination with features, characteristics and/or elements described in connection with another embodiment, unless expressly stated otherwise. It will, therefore, be understood by those skilled in the art that various changes in form and details may be made therein without departing from the scope of the present disclosure as set forth in the appended claims.

## Claims

1.  A heat dissipation control method, comprising:

    acquiring (S11), in response to receiving a distance between a device operator and a device, a temperature of a device surface (A, B, C, D); and determining (S12) a heat dissipation mode for the device according to the distance between the device operator and the device, the temperature of the device surface, a preset distance threshold and a preset temperature threshold; and
    controlling (S13) the device to perform heat dissipation according to the heat dissipation mode,
    wherein the distance between the device operator and the device is a distance between the device operator and the device in each direction, and acquiring the temperature of the device surface comprises: acquiring (S11') a temperature of a device surface corresponding to each direction;
    wherein determining the heat dissipation mode for the device according to the distance between the device operator and the device, the temperature of the device surface, the preset distance threshold and the preset temperature threshold comprises: determining a heat dissipation mode for the device in each direction according to the distance between the device operator and the device in each direction, the temperature of the device surface corresponding to each direction, the preset distance threshold and the preset temperature threshold; and
wherein the distance threshold comprises a first distance threshold and a second distance threshold, and the temperature threshold comprises a first temperature threshold and a second temperature threshold, and wherein determining the heat dissipation mode for the device in each direction according to the distance between the device operator and the device in each direction, the temperature of the device surface corresponding to each direction, the preset distance threshold and the preset temperature threshold comprises:
in a first direction between the device operator and the device, in response to a distance between the device operator and the device in the first direction greater than the second distance threshold and less than or equal to the first distance threshold, and a temperature of a device surface corresponding to the first direction greater than or equal to the first temperature threshold, or in response to the distance between the device operator and the device in the first direction greater than or equal to zero and less than or equal to the second distance threshold, and the temperature of the device surface corresponding to the first direction less than the first temperature threshold and greater than or equal to the second temperature threshold, determining that the heat dissipation mode of the device in the first direction is reducing an amount of heat delivered by a heat dissipation channel (J, K, L, M) of the device in the first direction.

2.  The method according to claim 1, wherein determining the heat dissipation mode for the device in each direction according to the distance between the device operator and the device in each direction, the temperature of the device surface corresponding to each direction, the preset distance threshold and the preset temperature threshold further comprises:
in the first direction between the device operator and the device, in response to the distance between the device operator and the device in the first direction greater than the second distance threshold and less than or equal to the first distance threshold, and the temperature of the device surface corresponding to the first direction less than the first temperature threshold, or in response to the distance between the device operator and the device in the first direction greater than or equal to zero and less than or equal to the second distance threshold, and the temperature of the device surface corresponding to the first direction less than the second temperature threshold, determining that the heat dissipation mode of the device in the first direction is maintaining the amount of heat delivered by the heat dissipation channel of the device in the first direction.

3. The method according to claim 1, wherein determining the heat dissipation mode for the device in each direction according to the distance between the device operator and the device in each direction, the temperature of the device surface corresponding to each direction, the preset distance threshold and the preset temperature threshold further comprises:
in the first direction between the device operator and the device, in response to the distance between the device operator and the device in the first direction greater than zero and less than or equal to the second distance threshold, and the temperature of the device surface corresponding to the first direction greater than or equal to the first temperature threshold, determining that the heat dissipation mode of the device in the first direction is closing the heat dissipation channel of the device in the first direction, or determining that the heat dissipation mode of the device in the first direction is closing the heat dissipation channel of the device in the first direction and turning on a heat dissipation apparatus (40) for the device surface corresponding to the first direction.

4. The method according to any one of claims 1 to 3, wherein after acquiring the temperature of the device surface corresponding to each direction, the method further comprises:
giving (S12') an alarm in the first direction between the device operator and the device, in response to the temperature of the device surface corresponding to the first direction greater than or equal to the second temperature threshold.

5. A heat dissipation control apparatus, comprising: a receiving module (101), a processing module (102) and a control module (103), wherein

   the receiving module is configured to receive a distance between a device operator and a device;
   the processing module is configured to acquire, in response to that the receiving module receives the distance between the device operator and the device, a temperature of a device surface; and determine a heat dissipation mode for the device according to the distance between the device operator and the device, the temperature of the device surface, a preset distance threshold and a preset temperature threshold;
   the control module is configured to control the device to perform heat dissipation according to the heat dissipation mode;
   the distance between the device operator and the device is a distance between the device operator and the device in each direction;
the processing module is configured to acquire a temperature of a device surface corresponding to each direction; and determine, according to the distance between the device operator and the device in each direction, the temperature of the device surface corresponding to each direction, the preset distance threshold and the preset temperature threshold, a heat dissipation mode for the device in each direction.
the distance threshold comprises a first distance threshold and a second distance threshold, and the temperature threshold comprises a first temperature threshold and a second temperature threshold; and
the processing module is configured to, in a first direction between the device operator and the device, in response to a distance between the device operator and the device in the first direction greater than the second distance threshold and less than or equal to the first distance threshold, and a temperature of a device surface corresponding to the first direction greater than or equal to the first temperature threshold, or in response to the distance between the device operator and the device in the first direction greater than or equal to zero and less than or equal to the second distance threshold, and the temperature of the device surface corresponding to the first direction less than the first temperature threshold and greater than or equal to the second temperature threshold, determine that the heat dissipation mode of the device in the first direction is reducing an amount of heat delivered by a heat dissipation channel of the device in the first direction.

6. The heat dissipation control apparatus according to claim 5, wherein,
the processing module is configured to, in the first direction between the device operator and the device, in response to the distance between the device operator and the device in the first direction greater than the second distance threshold and less than or equal to the first distance threshold, and the temperature of the device surface corresponding to the first direction less than the first temperature threshold, or in response to the distance between the device operator and the device in the first direction greater than or equal to zero and less than or equal to the second distance threshold, and the temperature of the device surface corresponding to the first direction less than the second temperature threshold, determine that the heat dissipation mode of the device in the first direction is maintaining the amount of heat delivered by the heat dissipation channel of the device in the first direction.

7. The heat dissipation control apparatus according to claim 5, wherein,
the processing module is configured to, in the first direction between the device operator and the device, in response to the distance between the device operator and the device in the first direction greater than zero and less than or equal to the second distance threshold, and the temperature of the device surface corresponding to the first direction greater than or equal to the first temperature threshold, determine that the heat dissipation mode of the device in the first direction is closing the heat dissipation channel of the device in the first direction, or determine that the heat dissipation mode of the device in the first direction is closing the heat dissipation channel of the device in the first direction and turning on a heat dissipation apparatus for the device surface corresponding to the first direction.

8. The heat dissipation control apparatus according to any one of claim 5 to 7, wherein,
the processing module is configured to give an alarm in the first direction between the device operator and the device, in response to the temperature of the device surface corresponding to the first direction greater than or equal to the second temperature threshold.

9. A computer-readable medium storing a computer program thereon, wherein the program, when executed by the apparatus of claim 5, causes said apparatus to implement the steps of the heat dissipation control method according to any one of claims 1 to 4.

**Patentansprüche**

1. Verfahren zur Steuerung der Wärmeableitung, umfassend:

Erfassen (S11), als Reaktion auf das Empfangen eines Abstands zwischen einem Vorrichtungsbediener und einer Vorrichtung, einer Temperatur einer Vorrichtungsoberfläche (A, B, C, D); und
Bestimmen (S12) eines Wärmeableitungsmodus für die Vorrichtung gemäß dem Abstand zwischen dem Vorrichtungsbediener und der Vorrichtung, der Temperatur der Vorrichtungsoberfläche, einem voreingestellten Abstandsschwellenwert und einem voreingestellten Temperaturschwellenwert; und
Steuern (S13) der Vorrichtung zum Durchführen der Wärmeableitung gemäß dem Wärmeableitungsmodus,
wobei der Abstand zwischen dem Vorrichtungsbediener und der Vorrichtung ein Abstand zwischen dem Vorrichtungsbediener und der Vorrichtung in jeder Richtung ist und das Erfassen der Temperatur der Vorrichtungsoberfläche umfasst: Erfassen (S11') einer Temperatur einer Vorrichtungsoberfläche, die jeder Richtung entspricht;
wobei das Bestimmen des Wärmeableitungsmodus für die Vorrichtung gemäß dem Abstand zwischen dem Vorrichtungsbediener und der Vorrichtung, der Temperatur der Vorrichtungsoberfläche, dem voreingestellten Abstandsschwellenwert und dem voreingestellten Temperaturschwellenwert umfasst: Bestimmen eines Wärmeableitungsmodus für die Vorrichtung in jeder Richtung gemäß dem Abstand zwischen dem Vorrichtungsbediener und der Vorrichtung in jeder Richtung, der Temperatur der Vorrichtungsoberfläche, die jeder Richtung entspricht, dem voreingestellten Abstandsschwellenwert und dem voreingestellten Temperaturschwellenwert; und
wobei der Abstandsschwellenwert einen ersten Abstandsschwellenwert und einen zweiten Abstandsschwellenwert umfasst und der Temperaturschwellenwert einen ersten Temperaturschwellenwert und einen zweiten Temperaturschwellenwert umfasst, und wobei das Bestimmen des Wärmeableitungsmodus für die Vorrichtung in jeder Richtung gemäß dem Abstand zwischen dem Vorrichtungsbediener und der Vorrichtung in jeder Richtung, der Temperatur der Vorrichtungsoberfläche, die jeder Richtung entspricht, dem voreingestellten Abstandsschwellenwert und dem voreingestellten Temperaturschwellenwert umfasst:
in einer ersten Richtung zwischen dem Vorrichtungsbediener und der Vorrichtung, als Reaktion auf einen Abstand zwischen dem Vorrichtungsbediener und der Vorrichtung in der ersten Richtung, der größer als der zweite Abstandsschwellenwert und kleiner oder gleich dem ersten Abstandsschwellenwert ist, und eine Temperatur einer Vorrichtungsoberfläche, die der ersten Richtung entspricht, die größer oder gleich dem ersten Temperaturschwellenwert ist, oder als Reaktion auf den Abstand zwischen dem Vorrichtungsbediener und der Vorrichtung in der ersten Richtung, der größer oder gleich null und kleiner oder gleich dem zweiten Abstandsschwellenwert ist, und die Temperatur der Vorrichtungsoberfläche, die der ersten Richtung entspricht, die kleiner als der erste Temperaturschwellenwert und größer oder gleich dem zweiten Temperaturschwellenwert ist, Bestimmen, dass der Wärmeableitungsmodus der Vorrichtung in der ersten Richtung eine Menge an Wärme reduziert, die durch einen Wärmeableitungskanal (J, K, L, M) der Vorrichtung in der ersten Richtung geliefert wird.

2. Verfahren nach Anspruch 1, wobei das Bestimmen des Wärmeableitungsmodus für die Vorrichtung in jeder Richtung gemäß dem Abstand zwischen dem Vorrichtungsbediener und der Vorrichtung in jeder Richtung, der Temperatur der Vorrichtungsoberfläche, die jeder Richtung entspricht, dem voreingestellten Abstandsschwellenwert und dem voreingestellten Temperaturschwellenwert ferner umfasst: in der ersten Richtung zwischen dem Vorrichtungsbediener und der Vorrichtung, als Reaktion auf den Abstand zwischen dem Vorrichtungsbediener und der Vorrichtung in der ersten Richtung, der größer als der zweite Abstandsschwellenwert und kleiner oder gleich dem ersten Abstandsschwellenwert ist, und die Temperatur der Vorrichtungsoberfläche, die der ersten Richtung entspricht, die kleiner als der erste Temperaturschwellenwert ist, oder als Reaktion auf den Abstand zwischen dem Vorrichtungsbediener und der Vorrichtung in der ersten Richtung, der größer oder gleich null und kleiner oder gleich dem zweiten Abstandsschwellenwert ist, und die Temperatur der Vorrichtungsoberfläche, die der ersten Richtung entspricht, die kleiner als der zweite Temperaturschwellenwert ist, Bestimmen, dass der Wärmeableitungsmodus der Vorrichtung in der ersten Richtung die Menge an Wärme, die durch den Wärmeableitungskanal der Vorrichtung in der ersten Richtung geliefert wird, beibehält.

3. Verfahren nach Anspruch 1, wobei das Bestimmen des Wärmeableitungsmodus für die Vorrichtung in jeder Richtung gemäß dem Abstand zwischen dem Vorrichtungsbediener und der Vorrichtung in jeder Richtung, der Temperatur der Vorrichtungsoberfläche, die jeder Richtung entspricht, dem voreingestellten Abstandsschwellenwert und dem voreingestellten Temperaturschwellenwert ferner umfasst: in der ersten Richtung zwischen dem Vorrichtungsbediener und der Vorrichtung, als Reaktion auf den Abstand zwischen dem Vorrichtungsbediener und der Vorrichtung in der ersten Richtung, der größer als null und kleiner oder gleich dem zweiten Abstandsschwellenwert ist, und die Temperatur der Vorrichtungsoberfläche, die der ersten Richtung entspricht, die größer oder gleich dem ersten Temperaturschwellenwert ist, Bestimmen, dass der Wärmeableitungsmodus der Vorrichtung in der ersten Richtung den Wärmeableitungskanal der Vorrichtung in der ersten Richtung schließt, oder Bestimmen, dass der Wärmeableitungsmodus der Vorrichtung in der ersten Richtung den Wärmeableitungskanal der Vorrichtung in der ersten Richtung schließt, und Einschalten einer Wärmeableitungsvorrichtung (40) für die Vorrichtungsoberfläche, die der ersten Richtung entspricht.

4. Verfahren nach einem der Ansprüche 1 bis 3, wobei nach dem Erfassen der Temperatur der Vorrichtungsoberfläche, die jeder Richtung entspricht, das Verfahren ferner umfasst: Ausgeben (S12') eines Alarms in der ersten Richtung zwischen dem Vorrichtungsbediener und der Vorrichtung als Reaktion auf die Temperatur der Vorrichtungsoberfläche, die der ersten Richtung entspricht, die größer oder gleich dem zweiten Temperaturschwellenwert ist.

5. Vorrichtung zur Steuerung der Wärmeableitung, umfassend: ein Empfangsmodul (101), ein Verarbeitungsmodul (102) und ein Steuermodul (103), wobei

das Empfangsmodul konfiguriert ist, um einen Abstand zwischen einem Vorrichtungsbediener und einer Vorrichtung zu empfangen; das Verarbeitungsmodul konfiguriert ist, um als Reaktion darauf, dass das Empfangsmodul den Abstand zwischen dem Vorrichtungsbediener und der Vorrichtung empfängt, eine Temperatur einer Vorrichtungsoberfläche zu erfassen; und einen Wärmeableitungsmodus für die Vorrichtung gemäß dem Abstand zwischen dem Vorrichtungsbediener und der Vorrichtung, der Temperatur der Vorrichtungsoberfläche, einem voreingestellten Abstandsschwellenwert und einem voreingestellten Temperaturschwellenwert zu bestimmen; das Steuermodul konfiguriert ist, um die Vorrichtung zum Durchführen der Wärmeableitung gemäß dem Wärmeableitungsmodus zu steuern; der Abstand zwischen dem Vorrichtungsbediener und der Vorrichtung ein Abstand zwischen dem Vorrichtungsbediener und der Vorrichtung in jeder Richtung ist; das Verarbeitungsmodul konfiguriert ist, um eine Temperatur einer Vorrichtungsoberfläche, die jeder Richtung entspricht, zu erfassen; und gemäß dem Abstand zwischen dem Vorrichtungsbediener und der Vorrichtung in jeder Richtung, der Temperatur der Vorrichtungsoberfläche, die jeder Richtung entspricht, dem voreingestellten Abstandsschwellenwert und dem voreingestellten Temperaturschwellenwert einen Wärmeableitungsmodus für die Vorrichtung in jeder Richtung zu bestimmen. der Abstandsschwellenwert einen ersten Abstandsschwellenwert und einen zweiten Abstandsschwellenwert umfasst und der Temperaturschwellenwert einen ersten Temperaturschwellenwert und einen zweiten Temperaturschwellenwert umfasst; und das Verarbeitungsmodul konfiguriert ist, um in einer ersten Richtung zwischen dem Vorrichtungsbediener und der Vorrichtung als Reaktion auf einen Abstand zwischen dem Vorrichtungsbediener und der Vorrichtung in der ersten Richtung, der größer als der zweite Abstandsschwellenwert und kleiner oder gleich dem ersten Abstandsschwellenwert ist, und eine Temperatur einer Vorrichtungsoberfläche, die der ersten Richtung entspricht, die größer oder gleich dem ersten Temperaturschwellenwert ist, oder als Reaktion auf den Abstand zwischen dem Vorrichtungsbediener und der Vorrichtung in der ersten Richtung, der größer oder gleich null und kleiner oder gleich dem zweiten Abstandsschwellenwert ist, und die Temperatur der Vorrichtungsoberfläche, die der ersten Richtung entspricht, die kleiner als der erste Temperaturschwellenwert und größer oder gleich dem zweiten Temperaturschwellenwert ist, zu bestimmen, dass der Wärmeableitungsmodus der Vorrichtung in der ersten Richtung eine Menge an Wärme reduziert, die durch einen Wärmeableitungskanal der Vorrichtung in der ersten Richtung geliefert wird.

**6.** Vorrichtung zur Steuerung der Wärmeableitung nach Anspruch 5, wobei
das Verarbeitungsmodul konfiguriert ist, um in der ersten Richtung zwischen dem Vorrichtungsbediener und der Vorrichtung als Reaktion auf den Abstand zwischen dem Vorrichtungsbediener und der Vorrichtung in der ersten Richtung, der größer als der zweite Abstandsschwellenwert und kleiner oder gleich dem ersten Abstandsschwellenwert ist, und die Temperatur der Vorrichtungsoberfläche, die der ersten Richtung entspricht, die kleiner als der erste Temperaturschwellenwert ist, oder als Reaktion auf den Abstand zwischen dem Vorrichtungsbediener und der Vorrichtung in der ersten Richtung, der größer oder gleich null und kleiner oder gleich dem zweiten Abstandsschwellenwert ist, und die Temperatur der Vorrichtungsoberfläche, die der ersten Richtung entspricht, die kleiner als der zweite Temperaturschwellenwert ist, zu bestimmen, dass der Wärmeableitungsmodus der Vorrichtung in der ersten Richtung die Menge an Wärme, die durch den Wärmeableitungskanal der Vorrichtung in der ersten Richtung geliefert wird, beibehält.

**7.** Vorrichtung zur Steuerung der Wärmeableitung nach Anspruch 5, wobei
das Verarbeitungsmodul konfiguriert ist, um in der ersten Richtung zwischen dem Vorrichtungsbediener und der Vorrichtung als Reaktion auf den Abstand zwischen dem Vorrichtungsbediener und der Vorrichtung in der ersten Richtung, der größer als null und kleiner oder gleich dem zweiten Abstandsschwellenwert ist, und die Temperatur der Vorrichtungsoberfläche, die der ersten Richtung entspricht, die größer oder gleich dem ersten Temperaturschwellenwert ist, zu bestimmen, dass der Wärmeableitungsmodus der Vorrichtung in der ersten Richtung den Wärmeableitungskanal der Vorrichtung in der ersten Richtung schließt, oder zu bestimmen, dass der Wärmeableitungsmodus der Vorrichtung in der ersten Richtung den Wärmeableitungskanal der Vorrichtung in der ersten Richtung schließt, und Einschalten einer Wärmeableitungsvorrichtung für die Vorrichtungsoberfläche, die der ersten Richtung entspricht.

**8.** Vorrichtung zur Steuerung der Wärmeableitung nach einem der Ansprüche 5 bis 7, wobei
das Verarbeitungsmodul konfiguriert ist, um einen Alarm in der ersten Richtung zwischen dem Vorrichtungsbediener und der Vorrichtung als Reaktion auf die Temperatur der Vorrichtungsoberfläche, die der ersten Richtung entspricht, die größer oder gleich dem zweiten Temperaturschwellenwert ist, auszugeben.

**9.** Computerlesbares Medium zum Speichern eines Computerprogramms darauf, wobei das Programm bei Ausführung durch die Vorrichtung nach Anspruch 5 bewirkt, dass die Vorrichtung die Schritte des Verfahrens zur Steuerung der Wärmeableitung nach einem der Ansprüche 1 bis 4 implementiert.

**Revendications**

**1.** Procédé de contrôle de dissipation thermique, comprenant les étapes consistant à :

acquérir (S11), en réponse à recevoir une distance entre un opérateur de dispositif et un dispositif, une température d'une surface de dispositif (A, B, C, D) ; et
déterminer (S12) un mode de dissipation thermique pour le dispositif en fonction de la distance entre l'opérateur de dispositif et le dispositif, de la température de la surface de dispositif, d'un seuil de distance prédéfini et d'un seuil de température prédéfini ; et
contrôler (S13) le dispositif pour réaliser une dissipation thermique en fonction du mode de dissipation thermique,
dans lequel la distance entre l'opérateur de dispositif et le dispositif est une distance entre l'opérateur de dispositif et le dispositif dans chaque direction, et acquérir la température de la surface de dispositif comprend les étapes consistant à : acquérir (S11') une température d'une surface de dispositif correspondant à chaque direction ;
dans lequel déterminer le mode de dissipation thermique pour le dispositif en fonction de la distance entre l'opérateur de dispositif et le dispositif, de la température de la surface de dispositif, du seuil de distance prédéfini et du seuil de température prédéfini comprend les étapes consistant à : déterminer un mode de dissipation thermique pour le dispositif dans chaque direction en fonction de la distance entre l'opérateur de dispositif et le dispositif dans chaque direction, de la température de la surface de dispositif correspondant à chaque direction, du seuil de distance prédéfini et du seuil de température prédéfini ; et

dans lequel le seuil de distance comprend un premier seuil de distance et un second seuil de distance, et le seuil de température comprend un premier seuil de température et un second seuil de température, et dans lequel déterminer le mode de dissipation thermique pour le dispositif dans chaque direction en fonction de la distance entre l'opérateur de dispositif et le dispositif dans chaque direction, de la température de la surface de dispositif correspondant à chaque direction, du seuil de distance prédéfini et du seuil de température prédéfini comprend les étapes consistant à :

dans une première direction entre l'opérateur de dispositif et le dispositif, en réponse à une distance entre l'opérateur de dispositif et le dispositif dans la première direction supérieure au second seuil de distance et inférieure ou égale au premier seuil de distance, et une température d'une surface de dispositif correspondant à la première direction supérieure ou égale au premier seuil de température, ou en réponse à la distance entre l'opérateur de dispositif et le dispositif dans la première direction supérieure ou égale à zéro et inférieure ou égale au second seuil de distance, et la température de la surface de dispositif correspondant à la première direction inférieure au premier seuil de température et supérieure ou égale au second seuil de température, déterminer que le mode de dissipation thermique du dispositif dans la première direction réduit une quantité de chaleur fournie par un canal de dissipation thermique (J, K, L, M) du dispositif dans la première direction.

2. Procédé selon la revendication 1, dans lequel déterminer le mode de dissipation thermique pour le dispositif dans chaque direction en fonction de la distance entre l'opérateur de dispositif et le dispositif dans chaque direction, de la température de la surface de dispositif correspondant à chaque direction, du seuil de distance prédéfini et du seuil de température prédéfini comprend en outre les étapes consistant à :
dans la première direction entre l'opérateur de dispositif et le dispositif, en réponse à la distance entre l'opérateur de dispositif et le dispositif dans la première direction supérieure au second seuil de distance et inférieure ou égale au premier seuil de distance, et la température de la surface de dispositif correspondant à la première direction inférieure au premier seuil de température, ou en réponse à la distance entre l'opérateur de dispositif et le dispositif dans la première direction supérieure ou égale à zéro et inférieure ou égale au second seuil de distance, et la température de la surface de dispositif correspondant à la première direction inférieure au second seuil de température, déterminer que le mode de dissipation thermique du dispositif dans la première direction maintient la quantité de chaleur fournie par le canal de dissipation thermique du dispositif dans la première direction.

3. Procédé selon la revendication 1, dans lequel déterminer le mode de dissipation thermique pour le dispositif dans chaque direction en fonction de la distance entre l'opérateur de dispositif et le dispositif dans chaque direction, de la température de la surface de dispositif correspondant à chaque direction, du seuil de distance prédéfini et du seuil de température prédéfini comprend en outre les étapes consistant à :
dans la première direction entre l'opérateur de dispositif et le dispositif, en réponse à la distance entre l'opérateur de dispositif et le dispositif dans la première direction supérieure à zéro et inférieure ou égale au second seuil de distance, et la température de la surface de dispositif correspondant à la première direction supérieure ou égale au premier seuil de température, déterminer que le mode de dissipation thermique du dispositif dans la première direction ferme le canal de dissipation thermique du dispositif dans la première direction, ou déterminer que le mode de dissipation thermique du dispositif dans la première direction ferme le canal de dissipation thermique du dispositif dans la première direction et activer un appareil de dissipation thermique (40) pour la surface de dispositif correspondant à la première direction.

4. Procédé selon l'une quelconque des revendications 1 à 3, dans lequel après avoir acquis la température de la surface de dispositif correspondant à chaque direction, le procédé comprend en outre les étapes consistant à :
émettre (S12') une alarme dans la première direction entre l'opérateur de dispositif et le dispositif, en réponse à la température de la surface de dispositif correspondant à la première direction supérieure ou égale au second seuil de température.

5. Appareil de contrôle de dissipation thermique, comprenant : un module de réception (101), un module de traitement (102) et un module de contrôle (103), dans lequel

le module de réception est configuré pour recevoir une distance entre un opérateur de dispositif et un dispositif ;

le module de traitement est configuré pour acquérir, en réponse au fait que le module de réception reçoit la distance entre l'opérateur de dispositif et le dispositif, une température d'une surface de dispositif ; et déterminer un mode de dissipation thermique pour le dispositif en fonction de la distance entre l'opérateur de dispositif et le dispositif, de la température de la surface de dispositif, d'un seuil de distance prédéfini et d'un seuil de température prédéfini ;

le module de contrôle est configuré pour contrôler le dispositif pour réaliser une dissipation thermique en fonction du mode de dissipation thermique ;

la distance entre l'opérateur de dispositif et le dispositif est une distance entre l'opérateur de dispositif et le dispositif dans chaque direction ;

le module de traitement est configuré pour acquérir une température d'une surface de dispositif correspondant à chaque direction ; et déterminer, en fonction de la distance entre l'opérateur de dispositif et le dispositif dans chaque direction, de la température de la surface de dispositif correspondant à chaque direction, du seuil de distance prédéfini et du seuil de température prédéfini, un mode de dissipation thermique pour le dispositif dans chaque direction ;

le seuil de distance comprend un premier seuil de distance et un second seuil de distance, et le seuil de température comprend un premier seuil de température et un second seuil de température ; et

le module de traitement est configuré pour, dans une première direction entre l'opérateur de dispositif et le dispositif, en réponse à une distance entre l'opérateur de dispositif et le dispositif dans la première direction supérieure au second seuil de distance et inférieure ou égale au premier seuil de distance, et une température d'une surface de dispositif correspondant à la première direction supérieure ou égale au premier seuil de température, ou en réponse à la distance entre l'opérateur de dispositif et le dispositif dans la première direction supérieure ou égale à zéro et inférieure ou égale au second seuil de distance, et la température de la surface de dispositif correspondant à la première direction inférieure au premier seuil de température et supérieure ou égale au second seuil de température, déterminer que le mode de dissipation thermique du dispositif dans la première direction réduit une quantité de chaleur fournie par un canal de dissipation thermique du dispositif dans la première direction.

**6.** Appareil de contrôle de dissipation thermique selon la revendication 5, dans lequel,
le module de traitement est configuré pour, dans la première direction entre l'opérateur de dispositif et le dispositif, en réponse à la distance entre l'opérateur de dispositif et le dispositif dans la première direction supérieure au second seuil de distance et inférieure ou égale au premier seuil de distance, et la température de la surface de dispositif correspondant à la première direction inférieure au premier seuil de température, ou en réponse à la distance entre l'opérateur de dispositif et le dispositif dans la première direction supérieure ou égale à zéro et inférieure ou égale au second seuil de distance, et la température de la surface de dispositif correspondant à la première direction inférieure au second seuil de température, déterminer que le mode de dissipation thermique du dispositif dans la première direction maintient la quantité de chaleur fournie par le canal de dissipation thermique du dispositif dans la première direction.

**7.** Appareil de contrôle de dissipation thermique selon la revendication 5, dans lequel,
le module de traitement est configuré pour, dans la première direction entre l'opérateur de dispositif et le dispositif, en réponse à la distance entre l'opérateur de dispositif et le dispositif dans la première direction supérieure à zéro et inférieure ou égale au second seuil de distance, et la température de la surface de dispositif correspondant à la première direction supérieure ou égale au premier seuil de température, déterminer que le mode de dissipation thermique du dispositif dans la première direction ferme le canal de dissipation thermique du dispositif dans la première direction, ou déterminer que le mode de dissipation thermique du dispositif dans la première direction ferme le canal de dissipation thermique du dispositif dans la première direction et activer un appareil de dissipation thermique pour la surface de dispositif correspondant à la première direction.

**8.** Appareil de contrôle de dissipation thermique selon l'une quelconque des revendications 5 à 7, dans lequel,
le module de traitement est configuré pour émettre une alarme dans la première direction entre l'opérateur de dispositif et le dispositif, en réponse à la température de la surface de dispositif correspondant à la première direction supérieure ou égale au second seuil de température.

**9.** Moyen lisible par ordinateur sur lequel est stocké un programme informatique, dans lequel le programme, lorsqu'il est exécuté par l'appareil selon la revendication 5, amène ledit appareil à mettre en œuvre les étapes du procédé de contrôle de dissipation thermique selon l'une quelconque des revendi-

cations 1 à 4.

Surface A

E                                 H

J

Surface B       K     Internal heat    M       Surface D
                    source

L

F                                G

Surface C

**FIG. 1**

Acquire a temperature of a device surface in response to receiving a distance between a device operator and a device    S11

Determine a heat dissipation mode for the device according to the distance between the device operator and the device, the temperature of the device surface, a preset distance threshold and a preset temperature threshold    S12

Control the device to perform heat dissipation according to the heat dissipation mode    S13

**FIG. 2**

Acquire a temperature of a device surface corresponding to each direction    S11'

Give an alarm in a first direction between the device operator and the device, in response to a temperature of a device surface corresponding to the first direction greater than or equal to the second temperature threshold    S12'

**FIG. 3**

101

| Receiving module |
|---|

102

| Processing module |
|---|

103

| Control module |
|---|

FIG. 4

20

| Distance detection apparatus |
|---|

30

| Temperature detection apparatus |
|---|

10

| Heat dissipation control apparatus |
|---|

40

| Heat dissipation apparatus |
|---|

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014262128 A1